# EUROPEAN PATENT SPECIFICATION

(11) **EP 0 544 131 B1**
(45) Date of publication and mention of the grant of the patent: **05.03.1997**
(21) Application number: 92118964.3
(22) Date of filing: 05.11.1992
(51) Int. Cl.: H01L 21/00

(54) **Method and apparatus for etching an edge face of a wafer**
Methode und Vorrichtung zum Ätzen des Randes einer Halbleiterscheibe
Méthode et appareil pour attaquer la cirfonférence d'une galette de silicium

(30) Priority: 20.11.1991 JP 329765/91; 24.09.1992 JP 279487/92
(43) Date of publication of application: 02.06.1993
(73) Proprietor: ENYA SYSTEMS LIMITED, Kawagoe-shi, Saitama-ken (JP)
(72) Inventor: Yukihiko, Terasawa, Fussa-shi, Tokyo (JP); Makoto, Hamano, Nishitama-gun, Tokyo (JP)
(74) Representative: Zumstein, Fritz, Dr.

(56) References cited:
- EP-A- 0 368 334
- US-A- 4 897 369
- US-A- 4 897 369
- PATENT ABSTRACTS OF JAPAN vol. 6, no. 243 (E-145)(1121) 2 December 1982
- PATENT ABSTRACTS OF JAPAN vol. 8, no. 235 (E-275)27 October 1984

## Description

The invention relates to an apparatus according to the preamble of claim 1.

US-A-4,897,369 discloses a method in which the edge of wafers is made to slide in contact with the surfaces of a pad soaked in acid substances and in which, during the process, the areas of the edge of the wafers that have been in contact with the pad are periodically washed with a special liquid.

In the production of semiconductor wafers, a chamfering process has been conducted wherein the edge face of a sliced wafer is chamfered by machining. By this chamfering process, the edge face tends to have a fine rough surface. If the edge face is left as such, smears are likely to attach thereto, dust is likely to form, and thermal strain is likely to occur.

Under such circumstances, in order to smooth the edge face of the wafer chamfered by machining, the above mentioned method has been conducted wherein only the edge face is treated by etching. Further there have been known a method wherein plural wafers are directly laminated (Japanese Unexamined Patent Publication No. 134935/1987), or a method wherein wafers are laminated while interposing a special spacer between them (Japanese Examined Patent Publication No. 57612/1991), and then the wafers are dipped in an etching liquid under such a laminated condition that only the edge face of the wafers would be exposed, whereby only the chamfered portion are etched.

By the above-mentioned methods, the edge face can be etched. However, the operation of laminating plural wafers is troublesome and is hardly automated. Further, the surface of the wafer is brought into contact with others, and thus the wafers are likely to be damaged when they are peeled one by one.

An apparatus has been proposed wherein a roller having a groove portion in which the edge face of the wafer may enter under non-contact condition, an etching liquid is retained by surface tension within the groove portion of the roller, and the edge face of the wafer is brought into contact with the etching liquid to conduct the etching treatment (Japanese Unexamined Patent Publication No. 316936/1989). However, in the above-mentioned apparatus, it is difficult to retain a predetermined amount of the etching liquid by surface tension within the groove portion of the roller. Further, in general, a semiconductor wafer has an orientation flat formed by cutting off a part of the periphery thereof in a straight form, and thus it is very troublesome to control the apparatus so that the edge face would be brought into contact with the etching liquid while rotating the wafer and having always the wafer non-contact condition with the groove portion. Further, it is impossible to etch the edge face of the wafer into the desired shape.

It is an object of the present invention to provide an apparatus for etching the edge face of the wafer by which such problems can be solved and the edge face of the wafer may be etched by treating it in single wafer processing.

An apparatus, by which the above-mentioned objects can be accomplished, is provided according to the features in the characterizing part of claim 1.

The present invention provides an apparatus for etching the edge face of the wafer wherein a gas stream is given which flows from the surface toward the periphery of the wafer, to prevent the gas of the etching liquid from taking place on the surface of the wafer.

The wafer rotates under such a condition that the center portion of the back surface is held by a chuck by suction. The etching roller is in contact with the edge face of the wafer and rotates under such a condition. On the periphery of the etching roller, an etching liquid composed of a mixed acid of e.g. hydrofluoric acid, nitric acid, acetic acid and the like, is supplied. On the edge face of the wafer, a small amount of the etching liquid is attached, and thus only the edge face is etched.

If the rotation of the wafer is reversed, the edge face of the wafer will be etched into even and highly precise condition. Further, at the same time, if a pure water washing roller is abutted to the edge face of the wafer at the portion opposite to the portion to which the etching roller is in contact with the wafer, or at any other portion, and the washing roller is rotated, washing with pure water can be conducted.

If the gas stream such as nitrogen gas is given along the surface of the wafer toward the periphery, the surface of the wafer will not be fogged by the gas of the etching liquid supplied to the etching roller.

Further, the etched shape of the edge face of the wafer depends on the shape of the contact portion with the etching roller, and thus a desired etched shape can be obtained by changing the shape of the contact portion.

The other objects and features of the present invention will become apparent to persons of ordinary skill in the art upon a reading of the following description of the present invention with reference to the accompanying drawings.

### BRIEF DESCRIPTION OF THE DRAWINGS

Fig. 1 is an explanatory plan view showing the diagrammatic structure of the apparatus for etching the edge face of the wafer of the present invention.

Fig. 2 is an explanatory front view showing the diagrammatic structure of the apparatus for etching the edge face of the wafer of the present invention.

Fig. 3 is a sectional view showing mainly the etching unit portion of the present invention.

Fig. 4 is a front view showing another embodiment of the etching roller of the present invention.

Fig. 5 is a sectional view showing mainly the washing unit portion of the present invention.

Fig. 6 is an explanatory plan view showing the diagrammatic structure of another embodiment of the apparatus for etching the edge face of the wafer of the present invention.

Fig. 7 is an enlarged plan view of the etching roller portion of the apparatus for etching the edge face of the wafer as shown in Fig. 6.

### DETAILED DESCRIPTION OF THE PREFERRED EMBODIMENTS

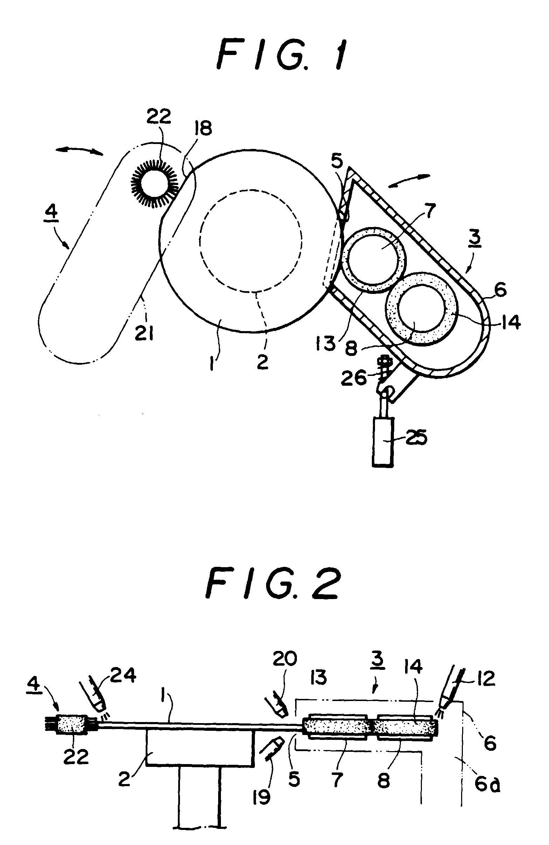

Figs. 1 and 2 are explanatory views showing the diagrammatic structures of the present invention. A wafer 1 is held by suction by means of a chuck means 2 such as a vacuum chuck, and is rotated under such a condition. An etching unit 3 and a washing unit 4 are disposed adjacent to the wafer 1.

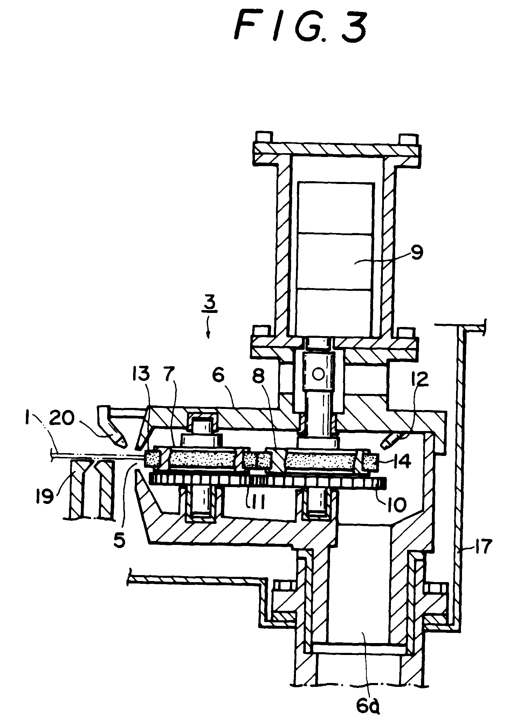

The etching unit 3 comprises a unit body 6 having an opening portion 5 formed at the portion facing to the edge face of the wafer 1 as shown in Fig. 3. Inside the unit body 6, an etching roller 7 facing to the opening portion 5 and a supplying roller 8 being in contact with the etching roller 7 are disposed. The supplying roller 8 is rotated by a motor 9, and the etching roller 7 is also rotated by way of gears 10, 11. The rotational speed of these rollers may be relatively low, for example, variable within the range of from 0 to 250 rpm, and usually at a rotational speed of about 60 rpm.

On the peripheries of the supplying roller 8 and the etching roller 7, contact members 13, 14 made of an appropriate material having chemical resistance e.g. a plastic material such as a vinyl chloride resin or a fluorine resin, are disposed to retain temporarily the etching liquid supplied from an etching liquid supplying nozzle 12. In the drawing, the contact members 13, 14 are made of a plastic foam material to have an elasticity. However, it may not be the- foam material, and may have a brush-like form. As shown in the drawing, the material of contact members is different from that of etching roller or supplying roller, but contact members can be formed integrately into etching roller or supplying roller. Thus it is unnecessary to provide contact members especially.

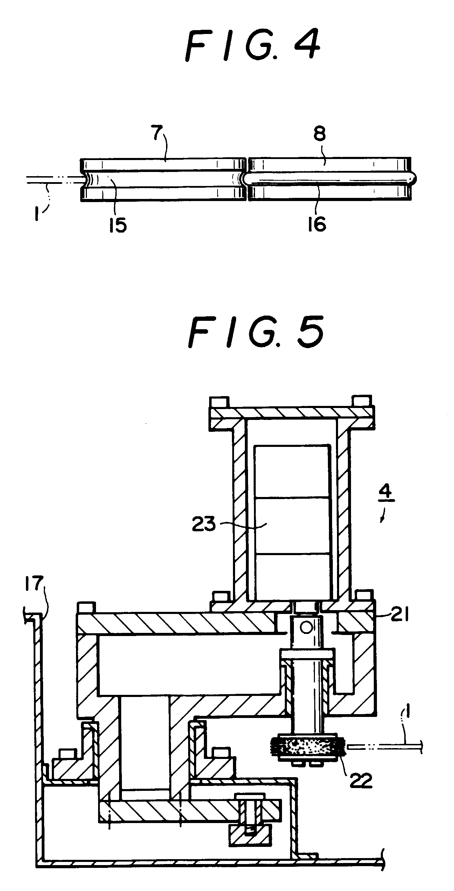

The etching roller 7 may have a groove 15 which allows the edge face of the wafer 1 to enter, as shown in Fig. 4. In this case, each roller has not contact members 13, 14, and the supplying roller 8 may have a raised portion 16 which corresponds to the groove 15. The shape of the groove 15 depends on the shape of the edge face of the wafer being in contact with the groove, by which the edge face may be etched into the desired shape.

In the embodiment as shown in the drawing, the etching liquid is indirectly supplied to the etching roller 7 by way of the supplying roller 8, whereby the etching liquid can be supplied evenly to the etching roller 7. The etching liquid is a mixed acid of hydrofluoric acid, nitric acid and acetic acid mixed in an appropriate proportion. However, those suitable to the purpose such as an alkali etching liquid may be used. In such a case, the portion to be treated may be heated to have the etching treatment accelerated. For example, the etching liquid may be heated by heating directly or by heating the rollers, or the wafer may be heated by disposing a heater at the portion adjacent to the chuck means 2 or the wafer 1 (not shown in the drawing).

The etching roller and the like are made of a material having chemical resistance as mentioned above. However, since it is unavoidable to cause the deterioration, it is preferred to design respective parts so that they may be easily disassembled and assembled. For example, it is possible to combine the etching roller or the supplying roller with the gears so that they are disconnectable in the axial direction, or change a part of the unit body into an open and shut system, to facilitate the operation for replacement.

The inside of the unit body 6 is constituted so that the gas of the etching liquid would not flow out of the opening portion 5. In the drawing, an exhaust device (not shown in the drawing) is disposed within the discharging path 6a disposed under the unit body 6, to exhaust downwardly the air within the unit body 6.

The etching unit 3 is rotatably disposed to an apparatus body 17, and is operated by an appropriate driving means such as an air cylinder 25 so that the etching unit may be located from the operating position where the etching roller 7 is abutted to the edge face of the wafer 1 to the backward position where the etching roller 7 is away from the wafer 1. The abutting pressure of the etching roller 7 against the wafer may be controlled to an appropriate pressure, for example, may be varied within the range of from 0.3 kg/cm² to 3 kg/cm², and usually at a pressure of about 1 kg/cm². such a pressure may be controlled by the above driving means.

At the operating position, the etching unit 3 is urged by a spring, appropriate weight or the like toward the wafer 1 so that the etching roller 7 would be securely in contact with an orientation flat portion 18 of the wafer. Such an urging means is constituted by providing a coil spring 26, for example, at the connecting portion of an air cylinder 25 and the etching unit to bias the etching unit toward the wafer.

The etching liquid supplied to the etching roller 7 as mentioned above tends to form a violent gas when the mixed acid as mentioned above is used. Since partial exhaustion may sometimes be unsatisfactory, a means is provided which allows a gas stream to flow along the surface of the wafer 1 toward the opening portion 5 of the etching unit 3 so that the gas would not flow on the surface or the back surface of the wafer 1.

In the drawing, on the back surface side and the upper surface side of the wafer 1, blow-off nozzles 19, 20 are disposed in a ring form along the periphery of the wafer toward the peripheral direction, so that the gas such as nitrogen gas would be blown in a ring form on the back surface and the upper surface of the wafer. The nozzle 20 at the upper surface side of the wafer, is disposed toward the opening portion 5 at an appropriate position of the exterior portion of the unit body 6 of the etching unit 3 so that the gas would be blown from the nozzle to the surface (Fig. 3). Further, when the surface of the wafer is polished at the posterior step, the blow-off nozzle at the surface side may not be used.

Further, in order to avoid the outflow of the gas of the etching liquid, a vacuum suction device may be disposed at the inside of the opening portion 5 of the unit body 6 to have the inside atmosphere of the unit body 6 highly reduced pressure condition by the vacuum action, or an air curtain may be formed at the opening portion.

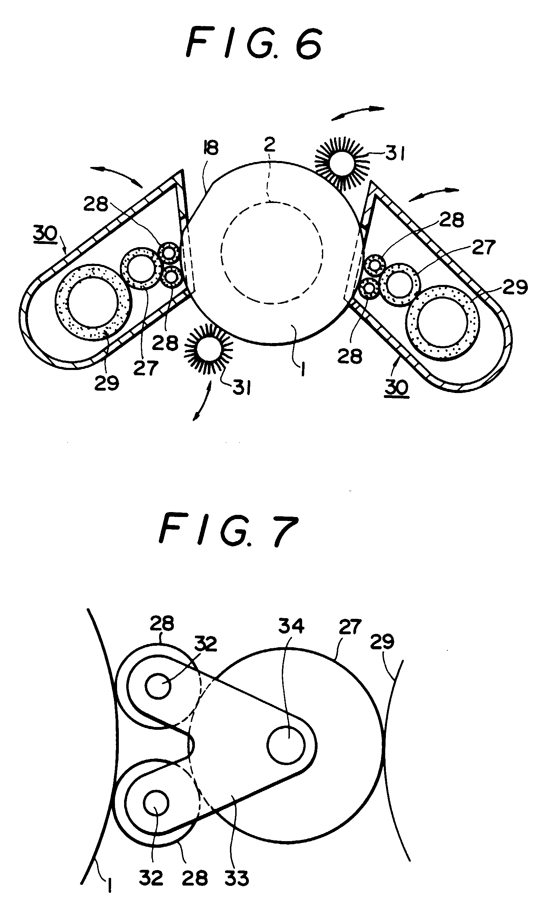

The washing unit 4 comprises, as shown in Fig. 5, an apparatus body 17, a washing unit body 21 rotatably disposed to the apparatus body, and a pure water washing roller 22 and a motor 23 which rotates the roller 22 are disposed to the washing unit body. The roller 22 is brought into contact with the edge face of the wafer 1 while supplying the pure water from a pure water nozzle 24 (in Fig. 2) disposed at an appropriate position onto the upper surface or the back surface of the wafer, whereby the edge face is washed. In the drawing, the washing roller 22 is a brush. However, an elastic roller having an elastic material such as a foam material disposed around the roller may sometimes be employed.

The contact pressure of the washing unit 4 against the edge face of the wafer 1, is preferably be controlled to the substantially same degree as the contact pressure of the etching unit 3. The driving means for rotating the washing unit and the urging means for urging the etching unit toward the wafer, are not shown in the drawing, and may have the substantially same structure as the etching unit. The washing unit 4 and the etching unit 3 are in contact with the edge face of the wafer 1 at the same time. However, the washing unit 4 may be brought into contact with the edge face of the wafer after the etching unit is abutted to the edge face of the wafer.

As mentioned above, the wafer is carried in and placed above the chuck 2 by means of an appropriate conveying means, and held by the chuck 2, and then rotated at a moderate rotational speed, for example, within the range of from 0 to 200 rpm, preferably at around 30 rpm. Then, the etching unit 3 is turned, thereby bringing the etching roller 7 into contact with the edge face of the wafer 1, and at the same time, the washing unit 4 is turned, thereby bringing the pure water washing roller 22 into contact with the edge face of the wafer. The contact pressures of the etching roller 7 and the pure water washing roller 22 are controlled at a constant level while rotating. The wafer is rotated in the reverse direction to the rotation of the etching roller and the washing roller. However, they may be rotated in the same direction.

Under such conditions, the etching liquid is transferred to the edge face of the wafer by means of the etching roller 7, and after the wafer is rotated in one direction by 5 turns, the wafer is rotated in the reverse direction by the substantially same turns, whereby the edge face of the wafer can be etched securely. Then, the etching unit or the like is moved backward, and the both surfaces of the wafer are rinsed with pure water, and spin-dried. The wafer is taken out from the chuck means by means of an appropriate conveying means, and the next wafer is carried therein.

In the above embodiment, one etching roller is used, but a plurality of etching rollers may be used. As plural etching rollers, plural etching units as shown in Fig. 1 may be disposed. In Fig. 6 is shown an embodiment of a structure comprising a pair of etching rollers 28, 28 which rotate under such a condition that the rollers are in contact with a supplying roller 27. The etching rollers 28, 28 preferably have a small diameter as compared with the supplying roller 27. By such constitution, fresh etching liquid is supplied continuously from a first supplying roller 29 to the small etching rollers 28, 28 by way of the supplying roller 27, whereby the etching treatment can be carried out with good efficiency. In the drawing, etching units 30 each having the etching rollers 28, 28 are disposed at two portions, and the washing units each having a washing roller 31 are disposed at two portions. The driving means for the etching unit or the washing unit is substantially the same as the above embodiment, and thus is not shown in the drawing. In addition, the structure or the like of the nozzles for blowing the nitrogen gas onto the upper surface or the back surface of the wafer is substantially the same as the above embodiment.

A frame 33 having shafts 32, 32 of the pair of the etching rollers 28, 28 installed, is swingably pivoted to a shaft 34 of the supplying roller 27. By such a structure, when the pair of the etching rollers 28, 28 are brought into contact with the orientation flat 18 of the wafer 1, they will pivotably move along the orientation flat 18, thereby securing the contact with the orientation flat 18 in the etching process.

The etching treatment of the edge face according to the present invention may be conducted at any step after the chamfering process by machining or before the surface polishing process. Further, the etching treatment can be conducted at any step in the semiconductor production as the case requires.

According to the present invention as constituted above, the etching treatment of the edge face of the wafer can be conducted in single wafer processing, the wafer is not damaged, the treatment can be conducted by full automation, and high surface precision as compared with the conventional lamination etching method can be attained.

## Claims

1. Apparatus for etching an edge face of a wafer, comprising an etching roller (7,28), a chuck means (2) for holding and rotating a wafer (1), and a means for supplying an etching liquid to a peripheral face of said etching roller (7, 28); characterised in that the apparatus comprises an etching unit (3) having an opening (5) at a portion facing to the edge face of the wafer and, inside the unit, the etching roller (7, 28) facing to said opening (5), means (19,20) for forming a gas stream flowing along the surface of the wafer toward the opening (5) of the etching unit (3); and means (25) for urging said etching unit (3) toward said wafer.

2. Apparatus according to Claim 1, wherein the means for supplying the etching liquid comprises a supplying roller (8,27,29) which rotates under such a condition that it is in contact with the etching roller (7, 28), and supplies the etching liquid to the etching roller (7, 28).

3. Apparatus according to Claim 1, which further comprises a washing unit (4) having a pure wafer supplying roller (22, 31) which is in contact with the edge face of the wafer and washes the edge face.

4. Apparatus according to Claim 1, wherein the etching roller (7, 28) is composed of a plurality of etching rollers which are in contact with the edge face of the wafer at the same time.

5. Apparatus according to Claim 2, wherein the etching roller is composed of a pair of etching rollers (28, 28) which rotate under such a condition that they are in contact with the same supplying roller.

6. Apparatus according to Claims 2 and 5, wherein the pair of etching rollers (28, 28) are arranged so that they may pivotably move with respect to the supplying roller (27).

7. A method for operating an apparatus according to claim 1, wherein the wafer (1) and the etching roller (7,28) are rotated under such a condition that the etching roller is in contact with the edge face of the wafer; an etching liquid is supplied on a peripheral face of the etching roller ( 7, 28); the etching liquid is transferred from the etching roller to the edge face of the wafer; and only the edge face of the wafer is etched.

8. Method according to Claim 7, which further comprises, after etching the edge face of the wafer, washing the edge face of the wafer by a pure water washing roller (22, 31).

## Patentansprüche

1. Vorrichtung zum Ätzen des Randes einer Halbleiterscheibe, die einen Ätzroller (7, 28), ein Spannmittel (2) zum Halten und Drehen einer Halbleiterscheibe (1) und Mittel für die Zufuhr einer Ätzflüssigkeit zu einer an der Außenseite befindlichen Fläche der genannten Ätzrollen (7, 28) aufweist,
**dadurch gekennzeichnet,**
daß die Vorrichtung eine Ätzeinheit (3) umfaßt, die eine Öffnung (5) an einem Abschnitt, der dem Rand der Halbleiterscheibe zugekehrt ist, und innerhalb der Einheit die Ätzrollen (7, 28) aufweist, die der Öffnung (5) zugekehrt sind, wobei Mittel (19, 20) zur Bildung eines Gasstroms vorgesehen sind, der entlang der Fläche der Halbleiterscheibe gegen die Öffnung (5) der Ätzeinheit (3) strömt; sowie ein Mittel (25), das die Ätzeinheit (3) gegen die Halbleiterscheibe drückt.

2. Vorrichtung nach Anspruch 1, wobei das Mittel für die Zufuhr der Ätzflüssigkeit eine Zuführrolle (8, 27, 29) umfaßt, die sich unter solch einer Bedingung dreht, daß sie in Kontakt mit der Ätzrolle (7, 28) ist und die Ätzflüssigkeit der Ätzrolle (7, 28) zuführt.

3. Vorrichtung nach Anspruch 1, die des weiteren eine Wascheinheit (4) umfaßt, die eine Zuführrolle (22, 31) für reines Wasser aufweist, die den Rand der Halbleiterscheibe berührt und den Rand wäscht.

4. Vorrichtung nach Anspruch 1, in welcher die Ätzrolle (7, 28) aus einer Vielzahl von Ätzrollen zusammengesetzt ist, die zur gleichen Zeit den Rand der Halbleiterscheibe berühren.

5. Vorrichtung nach Anspruch 2, in welcher die Ätzrolle aus einem Paar von Ätzrollen (28, 28) zusammengesetzt ist, die unter solch einer Bedingung sich drehen, daß sie die gleiche Zuführrolle berühren.

6. Vorrichtung nach Anspruch 2 und 5, in welcher das Ätzrollenpaar (28, 28) so angeordnet ist, daß es in Bezug auf die Zuführrolle (27) verschwenkbar ist.

7. Verfahren für den Betrieb einer Vorrichtung nach Anspruch 1, wobei die Halbleiterscheibe (1) und die Ätzrolle (7, 28) sich unter solch einer Bedingung drehen, daß die Ätzrolle den Rand der Halbleiterscheibe berührt; eine Ätzflüssigkeit auf die an der Außenseite befindlichen Fläche der Ätzrolle (7, 28) zugeführt wird, die Ätzflüssigkeit von der Ätzrolle zu dem Rand der Halbleiterscheibe befördert und nur der Rand der Halbleiterscheibe geätzt wird.

8. Verfahren nach Anspruch 7, weiterhin umfassend, daß nach dem Ätzen des Randes der Halbleiterscheibe der Rand der Halbleiterscheibe von einer Waschrolle (22, 31) für reines Wasser gewaschen wird.

## Revendications

1. Dispositif pour graver une face de bord d'une galette, comprenant un rouleau de gravure (7, 28), des moyens formant mandrin (2) pour maintenir et faire tourner une galette (1), et des moyens pour délivrer un liquide de gravure sur une face périphérique dudit rouleau de gravure (7, 28) ; caractérisé en ce que le dispositif comprend une unité de gravure (3) comportant une ouverture (5) dans une partie faisant face à la face de bord de la galette, et, à l'intérieur de l'unité, le rouleau de gravure (7, 28) faisant face à ladite ouverture (5), des moyens (19, 20) pour former un courant de gaz s'écoulant le long de la surface de la galette en direction de l'ouverture (5) de l'unité de gravure (3) ; et des moyens (25) pour pousser ladite unité de gravure (3) en direction de ladite galette.

2. Dispositif selon la revendication 1, dans lequel les moyens pour délivrer le liquide de gravure comprennent un rouleau de délivrance (8, 27, 29) qui tourne dans une condition telle qu'il soit en contact avec le rouleau de gravure (7, 28), et délivre le liquide de gravure au rouleau de gravure (7, 28).

3. Dispositif selon la revendication 1, qui comprend de plus une unité de lavage (4) comportant un rouleau de délivrance d'eau pure (22, 31) qui est en contact avec la face de bord de la galette et qui lave la face de bord.

4. Dispositif selon la revendication 1, dans lequel le rouleau de gravure (7, 28) se compose d'une pluralité de rouleaux de gravure qui sont en contact avec la face de bord de la galette en même temps.

5. Dispositif selon la revendication 2, dans lequel le rouleau de gravure se compose d'une paire de rouleaux de gravure (28, 28) qui tournent dans une condition telle qu'ils soient en contact avec le même rouleau de délivrance.

6. Dispositif selon les revendications 2 et 5, dans lequel la paire de rouleaux de gravure (28, 28) est disposée de telle sorte qu'ils puissent se déplacer par pivotement par rapport au rouleau de délivrance (27).

7. Procédé pour actionner un dispositif selon la revendication 1, dans lequel la galette (1) et le rouleau de gravure (7, 28) tournent dans une condition telle que le rouleau de gravure soit en contact avec la face de bord de la galette ; un liquide de gravure est délivré sur une face périphérique du rouleau de gravure (7, 28) ; le liquide de gravure est transféré du rouleau de gravure sur la face de bord de la galette ; et seule la face de bord de la galette est gravée.

8. Procédé selon la revendication 7, qui comprend de plus, après gravure de la face de bord de la galette, le lavage de la face de bord de la galette par un rouleau de lavage à l'eau pure (22, 31).
